**Europäisches Patentamt**

**European Patent Office**

**Office européen des brevets**

(19)

(11) Veröffentlichungsnummer: **0 026 376**

**A2**

(12) # EUROPÄISCHE PATENTANMELDUNG

(21) Anmeldenummer: **80105475.0**

(22) Anmeldetag: **12.09.80**

(51) Int. Cl.$^3$: **H 01 L 21/82**
**H 01 L 29/78, H 01 L 29/60**
**H 01 L 29/62**

(30) Priorität: **28.09.79 DE 2939456**

(43) Veröffentlichungstag der Anmeldung:
**08.04.81 Patentblatt 81/14**

(84) Benannte Vertragsstaaten:
**CH FR GB IT LI NL SE**

(71) Anmelder: **SIEMENS AKTIENGESELLSCHAFT Berlin
und München
Postfach 22 02 61
D-8000 München 22(DE)**

(72) Erfinder: **Widmann, Dietrich, Dr.-Ing.
Ludwig-Steub-Strasse 2
D-8025 Unterhaching(DE)**

(54) **Verfahren zur Herstellung von integrierten Halbleiterschaltungen, insbesondere CCD-Schaltungen mit selbstjustierten, nichtüberlappenden Poly-Silizium-Elektroden.**

(57) Die Erfindung betrifft ein Verfahren zur Herstellung von integrierten Halbleiterschaltungen, insbesondere CCD-Schaltungen, mit selbstjustierten, nichtüberlappenden Poly-Silizium-Elektroden, bei denen die laterale Ausdehnung der Elektroden in die Größenordnung der Schichtdicken fällt.

Bei bekannten Doppel-Silizium- Gate-Prozessen (Si$^2$-Gate-Prozessen) findet eine unvermeidliche Überlappung statt.

Eine solche Überlappung ist wegen der erhöhten Koppelkapazität und der begrenzten Packungsdichte unerwünscht.

Es liegt die Aufgabe zugrunde, ein Herstellungsverfahren zur Erzeugung von integrierten Halbleiterschaltungen zu schaffen, durch das die Überlappungen vermeidbar sind.

Die Aufgabe wird wie folgt gelöst:

Bei der Ätzung der Poly-Si-1-Schicht werden im Bereich der aufzutragenden Poly-Si-2- Elektroden Höhlungen unter der Elektroden-Isolierschicht SiO$_2$ oder Si$_3$N$_4$ zur Erzeugung von Überhängen erzeugt. Bei einer folgenden Gasphasenabscheidung werden diese Höhlungen vollständig aufgefüllt. Die entstandene Poly-Si-2-Schicht wird so weit abgeätzt, daß ihre Oberfläche etwas unterhalb der Oberfläche der Isolierschicht liegt. Es besteht praktisch keinerlei Überlappung benachbarter Elektroden.

FIG 5

$t_1$ $\quad$ $t_2=2t_1$ $\quad$ $t_3=3t_1$ $\quad$ $t_4=4t_1$ $\quad$ $t_5=5t_1$

Poly-Si1 $\qquad\qquad$ Poly-Si2

SIEMENS AKTIENGESELLSCHAFT     Unser Zeichen
Berlin und München             VPA 79 P 7 1 8 5

Verfahren zur Herstellung von integrierten Halbleiterschaltungen, insbesondere CCD-Schaltungen, mit selbstjustierten, nichtüberlappenden Poly-Silizium-Elektroden

Die vorliegende Erfindung betrifft ein Verfahren zur Herstellung von integrierten Halbleiterschaltungen, insbesondere CCD-Schaltungen, mit selbstjustierten, nichtüberlappenden Poly-Silizium-Elektroden, bei denen die
laterale Ausdehnung der Elektroden in die Größenordnung der Schichtdicken fällt.

Bei den bekannten Doppel-Silizium-Gate-Prozessen ($Si^2$-
Gate-Prozessen) findet in aller Regel eine nach dem bekannten Herstellungsverfahren unvermeidliche Überlappung der Poly-Silizium-Elektroden der zweiten Poly-
Silizium-Strukturebene mit den Poly-Silizium-Elektroden der ersten Poly-Silizium-Strukturebene statt.

Eine solche Überlappung ist sowohl wegen der erhöhten
Koppelkapazität zwischen Poly-Si 1 und Poly-Si-2-Elek-

Pap 1 The / 27.9.1979

troden als auch wegen der begrenzten Packungsdichte der Elektroden unerwünscht.

Aus "IEEE Journal of Solid-State Circuits, Vol. SC 11, No. 1, February 1976" ist ein Prozeß zur Erzeugung selbstjustierter, nichtüberlappender Aluminium-Elektroden mit Hilfe der "anodischen Oxidation" und der sog. Lift-off-Technik bekannt, vgl. dort S. 203-207: "V.A. Browne and K.D. Perkins: A nonoverlapping Gate-Charge-Coupling Technology for Serial Memory and Signal Processing Applications". Eine Technik zur Herstellung von integrierten Halbleiterschaltungen, in denen ausschließlch Elektroden aus Poly-Silizium, die sich nicht überlappen, verwendet werden, ist bisher nicht bekannt.

Der vorliegenden Erfindung liegt die Aufgabe zugrunde, ein Herstellungsverfahren zur Erzeugung von integrierten Halbleiterschaltungen, insbesondere CCD-Schaltungen, zu schaffen, durch das die bei bekannten Herstellungsverfahren unvermeidlichen Überlappungen der ersten mit der zweiten Elektrodenstruktur vermeidbar sind.

Die der Erfindung zugrundeliegende Aufgabe wird durch ein Verfahren zur Herstellung von integrierten Halbleiterschaltungen, insbesondere CCD-Schaltungen, gelöst, mit dem selbstjustierte, nichtüberlappende Poly-Silizium-Elektroden in zwei Ebenen erzeugbar sind.

Das erfindungsgemäße Verfahren ist dadurch gekennzeichnet, daß bei der Ätzung von Poly-Silizium-Elektroden einer ersten Art Poly-Si-1 die maskierenden $SiO_2$- oder $Si_3N_4$- Strukturen zur Erzeugung von Überhängen 5 der die Elektroden bedeckenden $SiO_2$- oder $Si_3N_4$- Schicht seitlich so weit unterätzt werden, daß jeweils ein Überhang 5 mit einer vorgegebenen Mindestlänge entsteht, daß anschließend die nun bestehenden Kanten der Poly-Silizium-Strukturen zur Isolation mit einer $SiO_2$- Schicht belegt werden, daß daran anschliessend die gesamte Oberfläche der Schaltungsstruktur mittels der an sich bekannten Gasphasenabscheidung CVD mit einer zweiten Poly-Silizium-Schicht Poly-Si-2 belegt wird, wobei entsprechend den Eigenschaften der an sich bekannten Gasphasenabscheidung CVD nicht nur die Höhlungen unter den Überhängen 5, sondern bei genügend kleinen Abstand der Kanten der $SiO_2$-Deckschicht auch der Zwischenraum zwischen den Poly-Si-1-Elektroden vollständig aufgefüllt werden, und daß in einem folgenden Verfahrensschritt die zweite Poly-Si-Schicht Poly-Si-2 mit einem ebenfalls an sich bekannten Ätzverfahren so weit abgetragen wird, daß ihre Oberfläche jeweils zumindest mit der Oberfläche der die in dieser Herstellungsphase die Poly-Si-1-Struktur deckende $SiO_2$-Schicht abschließt, wobei die geforderte nichtüberlappende Gesamtstruktur entsteht.

Die Erfindung bietet den Vorteil, daß die störenden, unerwünschte Kapazitäten zwischen benachbarten Elektroden innerhalb einer betreffenden integrierten Schaltungsanordnung, beispielsweise einer CCD-Schaltung, hervorrufenden Überlappungen, die durch Fertigungstoleranzen im allgemeinen unvermeidbar sind, mit einfachen Mitteln ausgeschlossen werden können.

Weiterbildungen der Erfindung sind durch die in den Unteransprüchen angegebenen Merkmale gekennzeichnet.

Im folgenden wird die Erfindung an Hand mehrerer, den Stand der Technik und Ausführungsbeispiele für die Erfindung betreffender Figuren erläutert.

Figur 1 zeigt schematisch den Querschnitt durch einen Teilbereich einer nach einem herkömmlichen Verfahren hergestellten Schaltungsstruktur, bei der sich eine Poly-Si-1-Schicht und eine Poly-Si-2-Schicht über eine geringe Breite überlappen.

Figur 2 zeigt schematisch den Querschnitt durch einen Teilbereich einer nach einem herkömmlichen Verfahren hergestellten Schaltungsstruktur, bei der die zweite Poly-Si-Schicht um den Betrag s eines Kantenlagefehlers in entgegengesetzter Richtung zu der betreffenden Elektrode der ersten Poly-Si-Schicht verschoben ist.

Figur 3 zeigt schematisch den Querschnitt durch einen Teilbereich einer nach einem herkömmlichen Verfahren hergestellten Schaltungsstruktur, bei der die zweite Poly-Si-Schicht um den Betrag s eines Kantenlagefehlers in Richtung der betreffenden Elektrode der ersten Poly-Si-Schicht verschoben ist.

Figur 4 zeigt schematisch den Querschnitt einer noch nicht vollständig nach der Erfindung aufgebauten Schaltungsstruktur mit einer auszugsweise gezeigten Poly-Si-1-Elektrode, die mit einer auf beiden Seiten einen Überhang 5 aufweisenden $Si-O_2$-Schicht bedeckt ist, deren Kantenabstände in der Größenordnung der Poly-Si-1-Schichtdicke liegen (z.B. 1 μm bei 0,5 μm Poly-Si-1-Dicke).

Figur 5 zeigt schematisch die gemäß Figur 4 aufgebaute Schaltungsstruktur, auf die mittels Gasphasenabscheidung eine Poly-Si-2-Schicht aufgetragen wird.

Figur 6 zeigt schematisch den Querschnitt durch eine nach Abätzen der überständigen Poly-Si-2-Schicht entstandenen Schaltungsstruktur, bei der keinerlei wesentliche Überlappung, mit Ausnahme der durch die gezeigten schrägen Kanten entstehenden minimalen Überlappungen der Elektroden vorliegt.

Figur 7 zeigt schematisch den Querschnitt durch einen peripheren Teilbereich der zuvor genannten Schaltungsanordnung, bei dem eine zweite Poly-Silizium-Schicht unter und über einem erfindungsgemäßen Überhang der Si-O$_3$-Schicht aufgebracht ist.

Figur 8 zeigt schematisch den Querschnitt durch einen Teilbereich der Schaltungsanordnung gemäß Figur 7, bei dem nach Wegätzen einer bestimmten Schichtstärke bei der zweiten Poly-Silizium-Schicht ein Rest dieser zweiten Poly-Silizium-Schicht in der Höhlung unter dem Überhang der SiO$_2$-Schicht verblieben ist.

Figur 9 zeigt schematisch den Querschnitt durch einen Teilbereich der Peripherie der betreffenden Schaltungsstruktur, bei dem vor dem Aufbringen der zweiten Poly-Silizium-Schicht der Überhang der SiO$_2$-Schicht durch einen besonderen Ätzvorgang beseitigt worden ist, und bei dem die zweite Poly-Silizium-Schicht in einem vorläufigen Verfahrensschritt aufgebracht ist.

Figur 10 zeigt schematisch den Querschnitt des in Figur 9 gezeigten Teilbereiches der betreffenden Schaltungsstruktur, bei dem die zweite Poly-Silizium-Schicht in den Bereichen der über der ersten Poly-Silizium-Schicht liegenden SiO$_2$-Schicht und der Feldoxid-Schicht 3 weggeätzt ist.

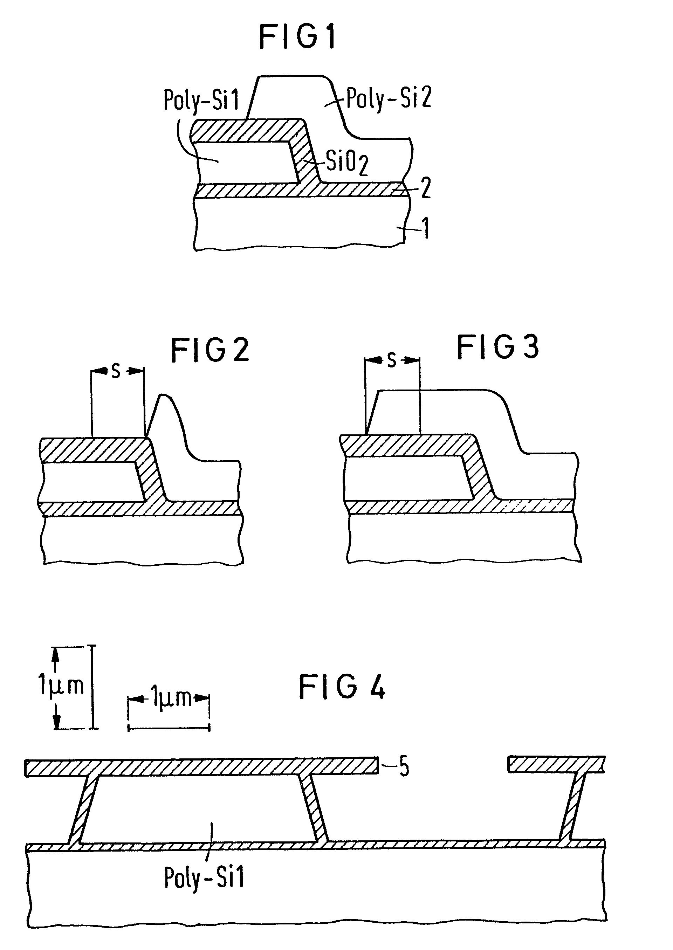

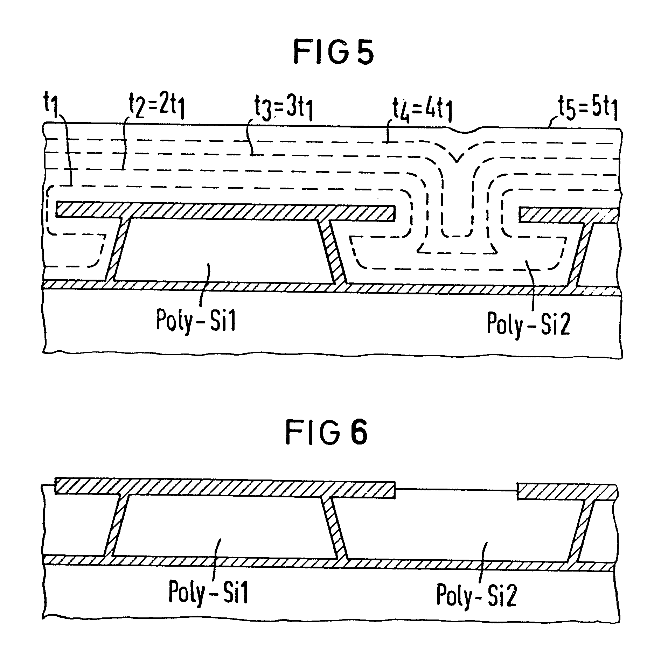

Wie bereits erläutert, zeigen die Figuren 4 bis 6 in mehreren Schritten die Herstellung einer integrierten Schaltungsanordnung, vorzugsweise einer CCD-Schaltung mit selbstjustierten, nicht überlappenden Elektroden, bei welcher Schaltungsanordnung die Poly-Si-Elektroden relativ schmal sind, d.h. daß ihre laterale Ausdehnung in die Größenordnung der Schichtdicken fällt. Unter dieser gegebenen Voraussetzung ist es mit Hilfe der Gasphasenabscheidung CVD möglich, die Höhlungen unter den Überhängen 5, vgl. Figur 4, beim Auftragen der Poly-Si-2-Schicht vollkommen auszufüllen, vgl. Figur 5. In Figur 5 sind die jeweils zu bestimmten Zeitpunkten $t_1$... $t_5$ entstandenen Schichtdicken durch die gestrichelten Linien schematisch angedeutet.

Figur 6 zeigt, wie bereits ebenfalls erläutert, schematisch den Querschnitt durch eine nach dem angegebenen Verfahren hergestellte Schaltungsstruktur. Es ist deutlich zu erkennen, daß sich die beiden benachbarten Elektroden nur unwesentlich, nämlich bedingt durch die schrägen Kanten, überlappen. Damit ist eine kapazitätsarme Anordnung gegeben.

Eine vorteilhafte Weiterbildung der Erfindung sieht vor, daß das Aufbringen der $SiO_2$-Schicht durch thermische Oxidation erfolgt, wobei dadurch, daß die Schichtdicke an den Kanten relativ groß wird, der Grad der genannten unwesentlichen Überlappung noch verringert wird.

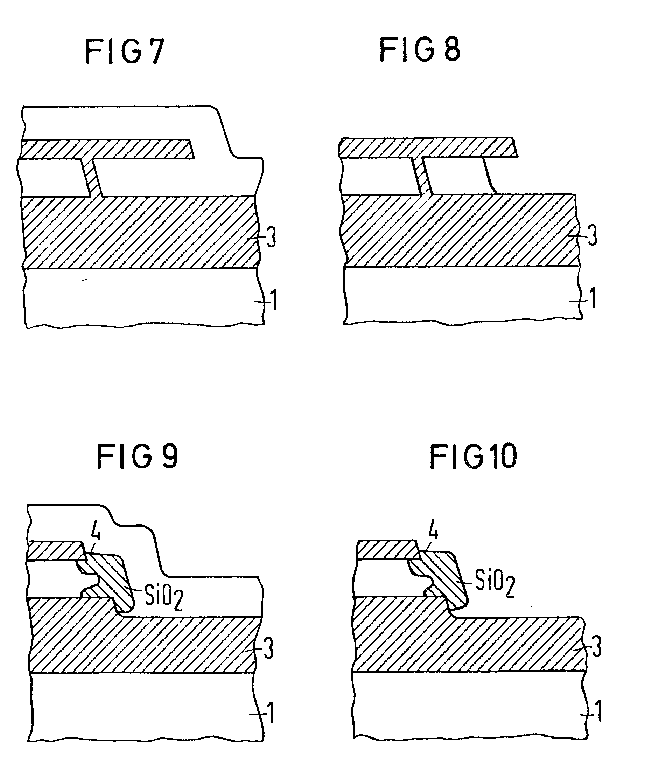

Eine andere Weiterbildung der Erfindung sieht vor, daß in den Bereichen, vorzugsweise in den peripheren Bereichen, in denen die erzeugten Poly-Si-2-Bahnen, z.B. die Funktion von Leiterbahnen haben, die Poly-Si-1-Bahnen kreuzen können, die Überhänge 5 vor dem Abscheiden der zweiten Poly-Si-Schicht Poly-Si-2 durch an sich bekannte Verfahrensschritte so weit weggeätzt werden, daß alle jeweils entstandenen Kontaktlochkanten 4 hinter den jeweils betreffenden Kanten der zugeordneten Poly-Si-1-Elektroden, nämlich auf den Flächen der betreffenden Elektroden, positioniert sind, so daß nach dem Wegätzen der in einem weiteren Verfahrensschritt aufgetragenen zweiten Poly-Si-Schicht Poly-Si-2 in den genannten Bereichen keine Kurzschlüsse verursachende Reste der zweiten Poly-Si-Schicht Poly-Si-2 verbleiben, vgl. Figuren 7 bis 10.

Im folgenden wird eine Folge von Verfahrensschritten angegeben, mit deren Hilfe die angestrebte Schaltungsstruktur herstellbar ist:

1. Erzeugung der Feldoxidbereiche, z.B. mit Hilfe der bekannten LOCOS-Technik.

2. Erzeugung der Gateoxidbereiche.

3. Gegebenenfalls Implantation von Dotierstoff in bestimmten Gate-Bereichen, z.B. zur Einstellung der Einsatzspannung von Transistoren.

4. Abscheidung einer ersten $n^+$-dotierten Poly-Silizium-Schicht (Poly-Si-1) mit Hilfe der Gasphasenabscheidung (CVD) bei ca. 700°C; Dicke der Poly-Si-1-Schicht ca. 0,8 μm (Es wird hier eine n-Kanal-MOS-Technik beschrieben. Die Überlegungen gelten aber in gleicher Weise auch für eine p-Kanal-MOS-Technik).

5. Abscheidung einer $SiO_2$-Schicht oder thermische Oxidation der Poly-Si-Schicht; Dicke der $SiO_2$-Schicht im Bereich von 0,05 bis 0,5 μm. Diese $SiO_2$-Schicht kann aber ggfs. auch ganz weggelassen werden.

6. Ätzung der $SiO_2$-Schicht, so daß die $SiO_2$-Schicht dort stehenbleibt, wo Poly-Si-1-Strukturen entstehen sollen. Die $SiO_2$-Stege im CCD-Kanalbereich seien z.B. 4,4 μm breit, der Abstand sei 1,6 μm.

8. Bereichsweises Wegätzen der maskierenden $SiO_2$-Schicht in der Umgebung der Poly-Si-1-Kanten zur Vermeidung von Kurzschlüssen zwischen benachbarten Poly-Si-2-Bahnen, wie oben beschrieben, vgl. Figur 7, 8, 9, 10.

9. Thermische Oxidation: Dabei wächst an den Poly-Si-1-Flanken eine $SiO_2$-Schicht in einer Dicke von 0,05 bis 0,3/um Dicke, während das Gateoxid in den nicht von Poly-Si-1 bedeckten Bereichen etwas weiterwächst. Falls das nicht erwünscht ist, können die nicht von Poly-Si-1 bedeckten Bereiche des Gateoxids vor der thermischen Oxidation weggeätzt werden, vgl. Fig. 4.

10. Gegebenenfalls Implantation von Dotierstoff in die freiliegenden Gateoxidbereiche zur Einstellung des Oberflächenpotentials an der $Si/SiO_2$-Grenzfläche unter den Poly-Si-2-Elektroden.

11. Abscheidung einer zweiten $n^+$-dotierten Poly-Si-Schicht (Poly-Si-2) mit Hilfe der Gasphasenabscheidung (CVD) bei ca. $700^{\circ}C$. Die Dicke der Poly-Si-2-Schicht soll ca. 1/um betragen. Bei der Gasphasenabscheidung zeigen die Poly-Si-Schichten das in Figur 10 dargestellte Aufwachsverhalten. Die Oberflächenkonturen werden nahezu gleichmäßig mit Poly-Si belegt. Dabei wird der Zwischenraum zwischen den Poly-Si-1-Elektroden auch von der Seite her aufgefüllt, so daß schließlich in diesen Bereichen eine erheblich dickere Poly-Si-Schicht aufwächst. Dieser Effekt wird zur Erzeugung selbstjustierter, nichtüberlappender Poly-Si-2-Elektroden genutzt.

12. Ätzen der Poly-Si-2-Schicht. Dabei wird die Poly-Si-2-Schicht in üblicher Weise überall dort mit einer Lackmaske bedeckt, wo Poly-Si-2-Bereiche entstehen sollen. Abweichend von dieser üblichen Maskierung wird hier aber im Bereich der CCD-Elektroden nicht mit Lack maskiert. Die Poly-Si-2-Schicht wird dann so weit abgetragen, daß Poly-Si-2 nur unter der Lackmaske sowie zwischen den Poly-Si-1-Elektroden stehenbleibt, vgl. Figur 6.

13. Erzeugung einer isolierenden Schicht (z.B. $SiO_2$).
14. Ätzen von Kontaktlöchern.
15. Erzeugung metallischer Leitbahnen.

Alle Prozeßschritte mit Ausnahme der Schritte 10) und 12) sind konventionell. Allerdings sind die Elektrodenbreite und die Poly-Si-2-Schichtdicke nicht unabhängig voneinander wählbar (vgl. angegebenes Zahlenbeispiel).

Wird der Schritt 13) mit Hilfe einer thermischen Oxidation ausgeführt, wächhst auch die $SiO_2$-Schicht zwischen Poly-Si-1 und Poly-Si-2-Elektroden etwas weiter, so daß die Koppelkapazität vorteilhafterweise weiter verringert werden kann.

Der in den Figuren 4, 5, 6 schematisch dargestellte Prozeßablauf kann allgemein zum Auffüllen von schmalen Gräben mit Poly-Si angewendet werden.

3 Patentansprüche
10 Figuren

Patentansprüche          79 P 7 1 8 5

1. Verfahren zur Herstellung von integrierten Halbleiterschaltungen, insbesondere CCD-Schaltungen, mit selbstjustierten, nichtüberlappenden Poly-Silizium-Elektroden, bei denen die laterale Ausdehnung der Elektroden in die Größenordnung der Schichtdicken fällt, dadurch g e - k e n n z e i c h n e t , daß bei der Ätzung von Poly-Silizium-Elektroden einer ersten Art (Poly-Si-1) die maskierenden $SiO_2$- oder $Si_3N_4$-Strukturen zur Erzeugung von Überhängen (5) der die Elektroden bedeckenden $SiO_2$- oder $Si_3N_4$-Schicht seitlich so weit unterätzt werden, daß jeweils ein Überhang (5) mit einer vorgegebenen Mindestlänge entsteht, daß anschließend die nun bestehenden Kanten der Poly-Silizium-Strukturen zur Isolation mit einer $SiO_2$-Schicht belegt werden, daß daran anschließend die gesamte Oberfläche der Schaltungsstruktur mittels der an sich bekannten Gasphasenabscheidung CVD mit einer zweiten Poly-Silizium-Schicht (Poly-Si-2) belegt wird, wobei entsprechend den Eigenschaften der an sich bekannten Gasphasenabscheidung CVD nicht nur die Höhlungen unter den Überhängen (5), sondern bei genügend kleinem Abstand der Kanten der $SiO_2$-Deckschicht auch der Zwischenraum zwischen den Poly-Si-1-Elektroden vollständig aufgefüllt werden, und daß in einem folgenden Verfahrensschritt die zweite Poly-Silizium-Schicht (Poly-Si-2) mit einem ebenfalls an sich bekannten Ätzverfahren so weit abgetragen wird, daß ihre Oberfläche jeweils zumindest mit der Oberfläche der die in diesen Herstellungsphase die Poly-Si-1-Struktur bedeckende $SiO_2$-Schicht abschließt, wobei die geforderte nichtüberlappende Gesamtstruktur entsteht.

2. Verfahren nach Anspruch 1, dadurch g e k e n n - z e i c h n e t , daß in den Bereichen, vorzugsweise in den peripheren Bereichen, in denen die erzeugten Poly-Si-2-Bahnen, z.B. die Funktion von Leiterbahnen haben, die Poly-Si-1-Bahnen kreuzen können, die Überhänge (5) vor dem Abscheiden der zweiten Poly-Silizium-Schicht (Poly-Si-2) durch an sich bekannte Verfahrensschritte so weit weggeätzt werden, daß alle jeweils entstandenen Kontaktlochkanten (4) hinter den jeweils betreffenden Kanten der zugeordneten Poly-Si-1-Elektroden, nämlich auf den Flächen der betreffenden Elektroden, positioniert sind, so daß nach dem Wegätzen der in einem weiteren Verfahrensschritt aufgetragenen zweiten Poly-Silizium-Schicht (Poly-Si-2) in den genannten Bereichen keine Kurzschlüsse verursachende Reste der zweiten Poly-Silizium-Schicht (Poly-Si-2) verbleiben.

3. Verfahren nach Anspruch 1, dadurch  g e k e n n  -  z e i c h n e t  , daß das Aufbringen der $SiO_2$-Schicht durch thermische Oxidation vorgenommen wird.

FIG 1

Poly-Si1    Poly-Si2

SiO₂

2

1

FIG 2                    FIG 3

s                        s

FIG 4

1 μm

1 μm

5

Poly-Si1

## FIG 5

$t_1$   $t_2=2t_1$   $t_3=3t_1$   $t_4=4t_1$   $t_5=5t_1$

Poly-Si1                    Poly-Si2

## FIG 6

Poly-Si1                    Poly-Si2

FIG 7

FIG 8

FIG 9

FIG 10

SiO₂

SiO₂